## Europäisches Patentamt
## European Patent Office
## Office européen des brevets

(19)

(11) Veröffentlichungsnummer: **0 019 865**
**B1**

(12) **EUROPÄISCHE PATENTSCHRIFT**

(45) Veröffentlichungstag der Patentschrift:
**09.02.83**

(51) Int. Cl.³: **H 03 K 17/56,** H 03 K 17/96,
**G 10 H 1/18**

(21) Anmeldenummer: **80102866.3**

(22) Anmeldetag: **22.05.80**

(54) **Digitale Halbleiterschaltung.**

(30) Priorität: **05.06.79 DE 2922752**

(43) Veröffentlichungstag der Anmeldung:
**10.12.80 Patentblatt 80/25**

(45) Bekanntmachung des Hinweises auf die Patenterteilung:
**09.02.83 Patentblatt 83/6**

(84) Benannte Vertragsstaaten:
**FR GB IT**

(56) Entgegenhaltungen:
**DE-A-2 654 575**
**DE-C-1 193 095**
**US-A-3 778 769**
**ELEKTRONIKPRAXIS, Nr. 4, April 1977 »IC für achtkanalige Berührungssteuerungen«, Seite 60**

(73) Patentinhaber: **SIEMENS AKTIENGESELLSCHAFT,
Berlin und München Wittelsbacherplatz 2,
D-8000 München 2 (DE)**

(72) Erfinder: **Rösler, Helmut, Ottobrunnerstrasse 101,
D-8000 München 83 (DE)**

## Digitale Halbleiterschaltung

Die Erfindung betrifft eine digitale Halbleiterschaltung mit mehreren, durch je einen Bedienungsschalter zu aktivierenden Schaltungsteilen, bei der jedem dieser Bedienungsschalter je eine bistabile Kippstufe zugeordnet und der Ruhezustand dieser einzelnen Schaltungsteile dem ersten Betriebszustand und ihr aktiver Zustand dem zweiten Betriebszustand der jeweils zugehörigen bistabilen Kippstufe zugeordnet ist, und bei der außerdem eine Logikschaltung derart vorgesehen ist, daß bei einer alleinigen Betätigung jedes der genannten Bedienungsschalter einerseits die Aktivierung des diesem Bedienungsschalter zugeordneten Schaltungsteils und andererseits die Rückschaltung jedes anderen im Zeitpunkt der Betätigung dieses Bedienungsschalters sich im aktiven Zustand befindlichen Schaltungsteils in den Ruhezustand erfolgt, bzw. der Ruhezustand der übrigen Schaltungsteile beibehalten wird.

Eine solche Halbleiterschaltung ist in der DE-OS 26 54 575 beschrieben. Bei der älteren Anordnung führt von jedem der als Sensorschalter ausgebildeten Bedienungsschalter eine Verbindung zu dem Setzeingang des jeweils zugehörigen Flip-Flops (also einer bistabilen Kippstufe). Die Reseteingänge dieser bistabilen Kippstufen werden durch je ein NOR-Gatter gesteuert, deren Eingänge durch die invertierten Ausgänge der jeweils übrigen bistabilen Kippstufen gesteuert sind. Wesentlich für die ältere Anordnung ist die Anwendung von Konstantstromquellen.

Die Erfindung hat demgegenüber das Ziel, eine digitale Halbleiterschaltung der eingangs angegebenen Art anzugeben, die ebenso wie die Schaltung nach der DE-OS in MOS-Technik realisierbar ist und die ohne Stromquellentransistoren auskommt und die auch für Schalter, die nicht als Sensorschalter ausgebildet sind, anwendbar ist.

Hierzu ist gemäß der Erfindung vorgesehen, daß die einzelnen durch je einen der Bedienungsschalter beaufschlagten n Signaleingänge der Logikschaltung über je einen Inverter zur Steuerung je eines NOR-Gatters dienen, daß dabei der eine Eingang dieser NOR-Gatter von dem zugehörigen Inverter und der zweite Eingang durch ein von einem weiteren Teil der Logikschaltung an alle diese NOR-Gatter geliefertes Sperrsignal beaufschlagt ist, daß ferner der Ausgang der genannten NOR-Gatter jeweils einen der beiden zur Steuerung der zugehörigen bistabilen Kippstufe dienenden Signalausgänge der Logikschaltung bildet, während der jeweils zugehörige zweite Signalausgang durch den Ausgang jeweils eines OR-Gatters gegeben ist, dessen $(n-1)$ Signaleingänge jeweils von je einem derjenigen Signaleingänge der Logikschaltung angesteuert sind, die den übrigen $(n-1)$ Bedienungsschaltern zugeordnet sind.

Damit wird geleistet, daß

1. jeweils nur ein einziger der genannten aktivierbaren Schaltungsteile sich im aktiven Betriebszustand befindet und alle übrigen dieser Schaltungsteile automatisch abgeschaltet sind,
2. bei laufendem Betrieb eines aktivierten Schaltungsteils dieser automatisch mit der Aktivierung jedes anderen dieser Schaltungsteile abgeschaltet wird.

Die erfindungsgemäße Anordnung kommt ohne Konstantstromquellen aus und läßt sich auch für Bedienungsschalter anwenden, die nicht als Berührungsschalter ausgebildet sind, obwohl auch diese, wie die weitere Beschreibung der Erfindung noch zeigen wird, in Verbindung mit der Erfindung vorteilhaft sind.

Die Erfindung eignet sich z. B. für Schaltungsteile, die der Erzeugung der verschiedenen musikalischen Betriebszustände elektronischer Musikinstrumente, z. B. einer elektronischen Orgel, dienen. Dort haben die verschiedenen Schaltungsteile die Aufgabe, musikalisch vertretbare Kombinationen von Tönen bzw. Rhythmen zu erzeugen. Ein gleichzeitiger Betrieb verschiedener dieser Schaltungsteile kann verständlicherweise zu unerwünschten Effekten führen. Andererseits ist aber erwünscht, daß mit dem Aktivieren des jeweils neuen Schaltungsteils der bisher im Betrieb befindliche Schaltungsteil automatisch zur Ruhe gebracht wird.

Die Erfindung wird nun anhand der Fig. 1 bis 3 beschrieben, wobei in Fig. 1 ein Blockschaltbild und in Fig. 2 ein der Erfindung entsprechendes Ausführungsbeispiel und in Fig. 3 eine Ausgestaltung dieses Ausführungsbeispiels in Ein-Kanal-MOS-Technik gezeigt ist. Diese eignet sich besonders für die monolithische Integration der erfindungsgemäßen Schaltung.

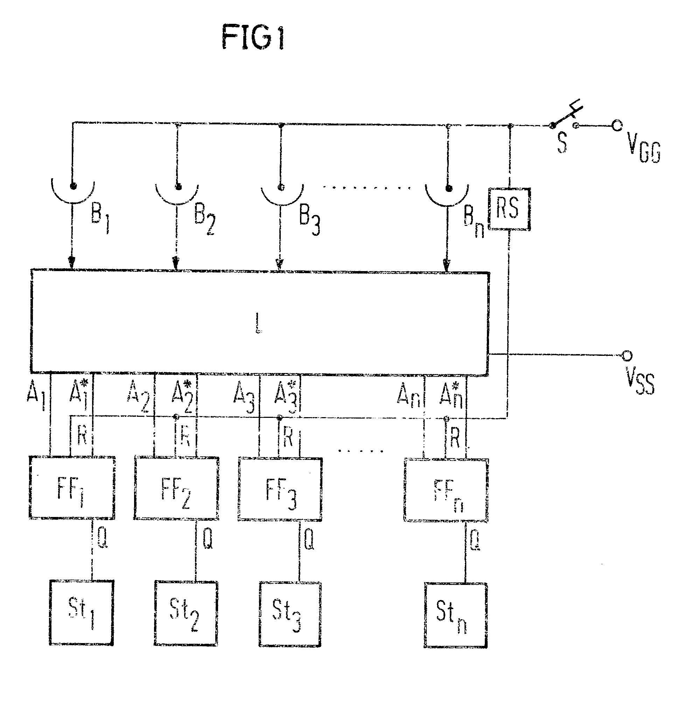

Wie aus Fig. 1 ersichtlich, können auch im Falle der Erfindung Sensorschalter verwendet werden, wie sie aus der DE-OS 26 54 575 ersichtlich sind. Ein solcher Sensorschalter besteht bekanntlich aus einer durch eines der Betriebspotentiale der Halbleiterschaltung beaufschlagten ersten Elektrode und einer mit dem betreffenden Signaleingang $E_i$ der Logikschaltung L verbundenen zweiten Elektrode, wobei die freie Strecke zwischen den beiden Elektroden des Sensorschalters $B_i$ bei seiner Betätigung durch einen Widerstand zu überbrücken ist, der durch den Finger der den Sensorschalter $B_i$ betätigenden Person gegeben ist. Demzufolge liegt an dem dem betreffenden Sensorschalter $B_i$ zugeordneten Eingang $E_i$ der Logikschaltung L nur solange ein dem Pegel der logischen »1« entsprechendes Signal, wie der Sensorschalter $B_i$ durch den Körper der bedienenden Person betätigt ist. Die Bedienungsschalter $B_i$ können aber andererseits auch normale monostabile Schalter (Taster) sein.

Jeder der n Bedienungsschalter $B_i$ ist je einem Signaleingang $E_i$ der gemeinsamen Logikschal-

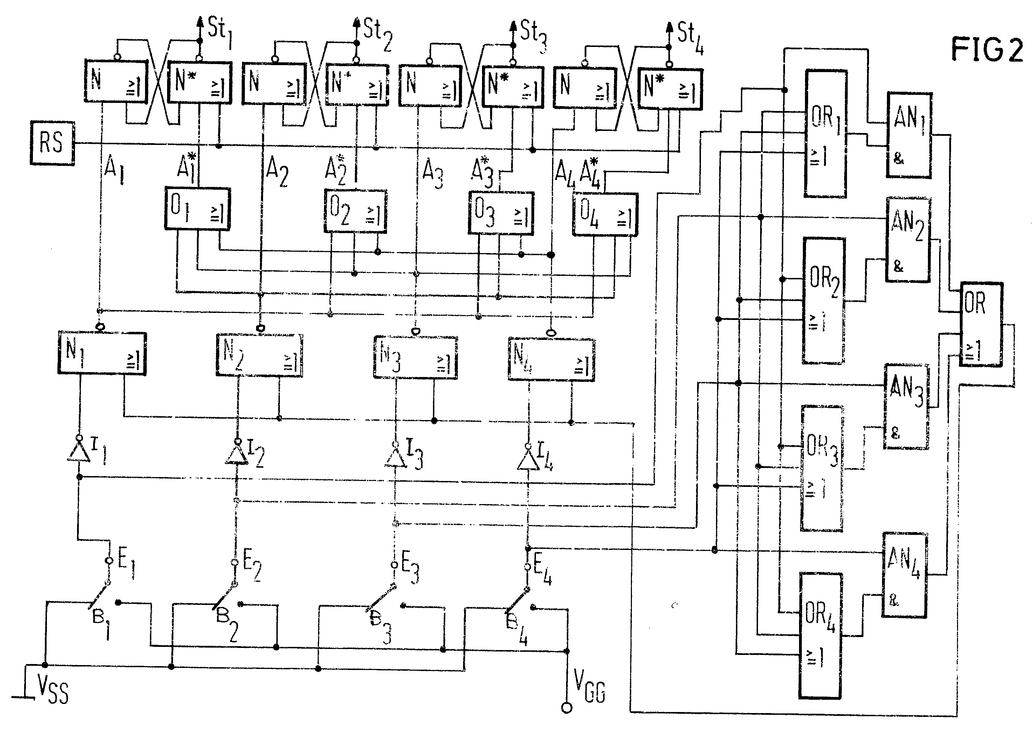

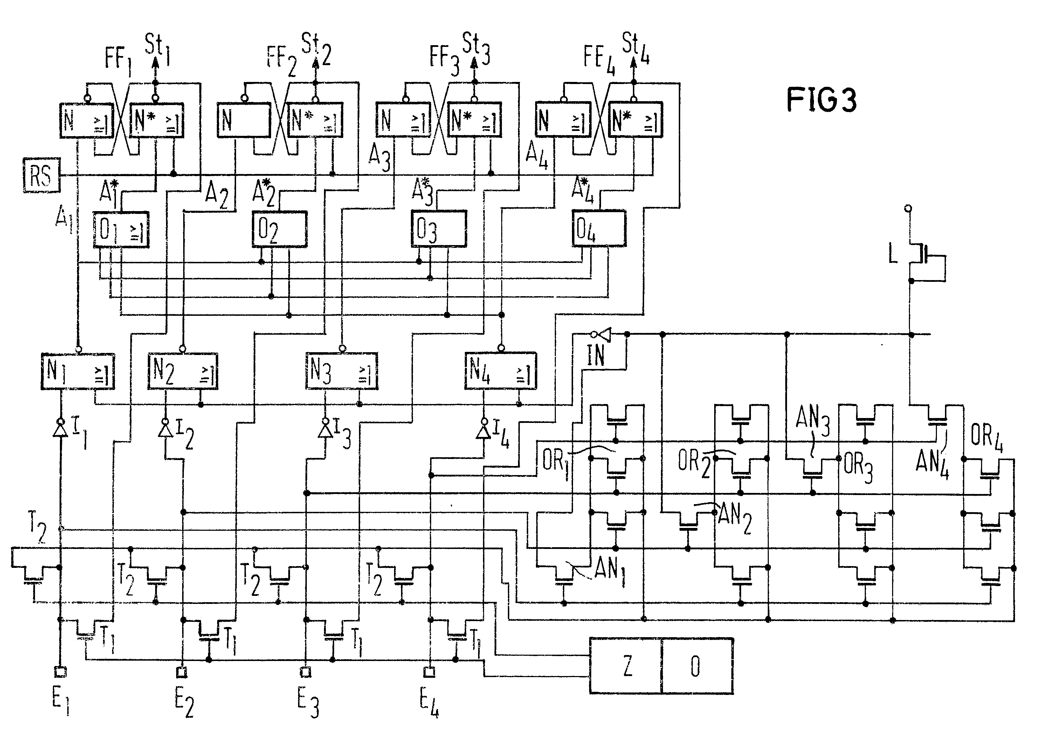

tung L zugeordnet. Neben den n Signaleingängen $E_1 \ldots E_n$ hat die Logikschaltung L auch 2 n Signalausgänge, die jeweils paarweise zusammengefaßt sind. Dabei ist das Ausgangspaar $A_i$, $A_i^*$ der Logikschaltung L ihrem Signaleingang $E_i$ und damit dem Bedienungsschalter $B_i$ zugeordnet, so daß also der Eingang $E_1$ zur Steuerung der Ausgänge $A_1$, $A_1^*$, der Eingang $E_2$ zur Steuerung der Ausgänge $A_2$, $A_2^*$ usw. vorgesehen ist. Jedes dieser Ausgangspaare $A_i$, $A_i^*$ dient zur Steuerung je einer bistabilen Kippstufe $FF_i$, also einer Flip-Flopzelle. Diese Flip-Flopzellen $FF_i$ sind insbesondere in gleicher Weise ausgestaltet, wie dies die Fig. 2 und 3 erkennen lassen.

Derjenige Ausgang der einzelnen bistabilen Kippstufe $FF_i$, der beim Fehlen einer logischen »1« an ihrem Signaleingang den logischen Pegel »0« aufweist, also ihr Q-Ausgang, dient zur Steuerung des über den ihr zugeordneten Bedienungsschalter $B_i$ zu aktivierenden Schaltungsteils $St_i$, dessen Aufbau beliebig sein kann und deshalb nicht näher zu beschreiben ist.

Neben dem über die einzelnen Bedienungsschalter $B_i$ an die einzelnen Signaleingänge $E_i$ der gemeinsamen Logikschaltung L zu legenden ersten Betriebspotential $V_{GG}$ ist noch ein zweites Betriebspotential $V_{SS}$ vorgesehen, das über Masse als Bezugspotential Verwendung findet und an die erforderlichen Stellen der Logikschaltung L, der einzelnen Flip-Flopzellen $FF_i$ und der weiteren Schaltungsteile $St_i$, ebenso wie das erste Betriebspotential $V_{GG}$, anzulegen ist. Dies geschieht z. B. mittels eines Schalters S. Mit dem Anschalten der beiden Betriebspotentiale wird ein Schaltungsteil RS aktiviert, dessen Ausgang einen Rücksetzimpuls an die Reseteingänge R der einzelnen Flip-Flopzellen $FF_i$ liefert. Hierdurch werden die im zweiten Betriebszustand befindlichen Flip-Flopzellen $FF_i$ automatisch in den ersten Betriebszustand übergeführt, während die Flip-Flopzellen $FF_i$ im ersten Betriebszustand den ersten Betriebszustand beibehalten.

Der erste Betriebszustand der einzelnen Flip-Flopzellen $FF_i$ ist dadurch gekennzeichnet, daß bei seinem Vorliegen der über die Flip-Flopzelle $FF_i$ einzuschaltende weitere Schaltungsteil $St_i$ sich im Ruhezustand befindet, während er mit dem Übergang der Flip-Flopzelle $FF_i$ in den zweiten Betriebszustand aktiviert wird.

Hinsichtlich der näheren Ausgestaltung der gemeinsamen Logikschaltung L geben die Fig. 2 und 3 ein vorteilhaftes Ausführungsbeispiel. In beiden Fällen ist die Gesamtzahl der Eingänge $E_i$ und damit auch der Bedienungsschalter $B_i$ sowie der durch diese zu aktivierenden weiteren Schaltungsteile jeweils n = 4.

Jeder der n Eingänge $E_i$ ist über je einen Inverter $I_i$ an den einen der beiden Eingänge je eines NOR-Gatters $N_i$ gelegt, während der zweite Eingang dieser NOR-Gatter $N_i$ an einer gemeinsamen Quelle für ein Sperrsignal liegt, die später im einzelnen beschrieben wird. Der Ausgang der einzelnen NOR-Gatter $N_i$ bildet je einen Signalausgang $A_i$ der Logikschaltung L.

Jeder der Eingänge $E_i$ ist über je einen der n Bedienungsschalter $B_i$ mit dem Pegel einer logischen »1« beaufschlagbar. Die Folge einer solchen Beaufschlagung ist, daß an dem zugehörigen Ausgang $A_i$ ebenfalls eine logische »1« erscheint. Diese logische »1« dient zur Steuerung des einen Signaleingangs der dem betreffenden Eingang $E_i$ und damit dem Ausgang $A_i$ der Logikschaltung L zugeordneten Flip-Flopzelle $FF_i$.

Jedes der NOR-Gatter $N_i$ ist außerdem an der Steuerung des logischen Zustandes der Ausgänge $A_j^*$ der Logikschaltung L (j = 1, . . . n) beteiligt, wovon nur der Fall j = i ausgenommen ist. Es wird also der Ausgang $A_i^*$ der Logikschaltung L nicht durch das den zugehörigen Ausgang $A_i$ bildende NOR-Gatter $N_i$ mitgesteuert.

Hierzu ist der mit dem jeweiligen Signalausgang $A_i$ der Logikschaltung L zu einem Ausgangspaar zusammengefaßte jeweilige Ausgang $A_i^*$ durch den Signalausgang je eines OR-Gatters $O_i$ gegeben, dessen (n−1) Signaleingänge jeweils mit dem Signalausgang je eines der NOR-Gatter $N_j$ verbunden sind, für welche die Bedingung j ≠ i erfüllt ist. In Alternative hierzu können die einzelnen Eingänge dieser OR-Gatter $O_i$ mit je einem der Signaleingänge $E_j$ der Logikschaltung verbunden sein, für die die Bedingung j ≠ i gilt.

Die einzelnen Eingänge $E_i$ der Logikschaltung L dienen außerdem zur Steuerung der das oben erwähnte Sperrsignal liefernden Quelle, die durch n weitere logische Einheiten gegeben ist, welche jeweils aus einer Kombination eines OR-Gatters $OR_i$ mit jeweils (n−1) Signaleingängen und eines AND-Gatters $AN_i$ mit jeweils zwei Eingängen bestehen und deren Ausgänge über ein weiteres gemeinsames OR-Gatter OR das Sperrsignal liefern.

Die in Fig. 3 dargestellte Anlage ist bezüglich der Ausgestaltung der Quelle für das Sperrsignal gegenüber der Anlage gemäß Fig. 2 etwas abweichend.

Bei der in Fig. 2 dargestellten Ausgestaltung liegt der einzelne Signaleingang $E_i$ der Logikschaltung L im Bereich der Erzeugung des Sperrsignals dienenden Teils der Logikschaltung an dem Eingang je eines der genannten AND-Gatter $AN_i$, dessen anderer Eingang durch das zu dem AND-Gatter $AN_i$ gehörende OR-Gatter $OR_i$ beaufschlagt ist. Die einzelnen Eingänge dieses OR-Gatters $OR_i$ sind mit jeweils einem der (n−1) Signaleingänge $E_j$ verbunden, welche die Bedingung j ≠ i erfüllen. Die Gesamtheit der Ausgänge der AND-Gatter $AN_i$ dient der Steuerung des genannten OR-Gatters OR, indem je einer der n Eingänge des OR-Gatters OR mit dem Ausgang je eines der n AND-Gatter $AN_i$ verbunden ist.  ·

Der Ausgang des gemeinsamen OR-Gatters OR schließlich liegt an den zweiten Eingängen der oben bereits beschriebenen n NOR-Gatter $N_i$ und steuert somit den logischen Pegel der Ausgänge $A_i$ und auf indirekte Weise der Ausgänge $A_i^*$ der Logikschaltung L mit.

Die jeweils durch ein Paar zusammengehörender Signalausgänge $A_i$, $A_i^*$ der Logikschaltung L gesteuerten n Flip-Flopzellen $FF_i$ sind im Beispielsfalle durch RS-Flip-Flops gegeben, deren beide Signaleingänge mit je einem der Ausgänge $A_i$, $A_i^*$ des zugeordneten Ausgangspaares der Logikschaltung L verbunden sind. Die einzelnen Flip-Flopzellen $FF_i$ bestehen aus kreuzgekoppelten NOR-Gattern N und $N^*$.

Zum Aufbau der einzelnen Flip-Flopzellen $FF_i$ ist der Ausgang der beiden NOR-Gatter N und $N^*$ der einzelnen Zelle an je einen Eingang des anderen Gatters gelegt und hierdurch eine Kreuzkopplung erzeugt. Das Gatter N hat noch einen zweiten Eingang der an den Ausgang $A_i$ des zugehörigen Ausgangspaares $A_i$, $A_i^*$ der Logikschaltung L gelegt ist. Das Gatter $N^*$ hat ebenfalls einen zweiten Eingang der mit dem Ausgang $A_i^*$ des zugehörigen Ausgangspaares verbunden ist. Das Gatter $N^*$ hat schließlich noch einen dritten Eingang, der durch die von der Anlage RS gelieferten Resetimpulse gesteuert ist und die Rückschaltung der betreffenden Flip-Flopzelle aus dem zweiten Betriebszustand in den ersten Betriebszustand ermöglicht. Ein von der Anlage RS abgegebener Resetimpuls sorgt beim Einschalten der Gesamtanlage über den Schalter S dafür, daß sämtliche Flip-Flopzellen $FF_i$ zunächst im ersten Betriebszustand sind. Der Ausgang der NOR-Gatter $N^*$ der einzelnen Flip-Flopzellen $FF_i$ ist außerdem der Q-Ausgang und gibt beim Übergang der betreffenden Flip-Flopzelle $FF_i$ in den zweiten Betriebszustand ein Aktivierungssignal an den durch das Flip-Flop $FF_i$ zu steuernden weiteren Schaltungsteil $St_i$ ab.

Wird nun durch Betätigung eines der Bedienungsschalter $B_i$ auf den zugehörigen Eingang $E_i$ der Logikschaltung L eine logische »1« gegeben, so erscheint diese »1« auch am Ausgang des NOR-Gatters $N_i$, sofern nicht an dessen zweiten Eingang eine von dem OR-Gatter OR gelieferte »1« anhängig ist. Über den Ausgang $A_i$ der Logik L gelangt diese »1« an den Eingang des NOR-Gatters N im Flip-Flop $FF_i$. Sie gelangt außerdem an je einen der (n−1) Eingänge von (n−1) OR-Gattern $O_j$, welche der Bedingung j ≠ i genügen. Dadurch erhalten die Ausgänge $A_j^*$ der Logik L ebenfalls eine »1«, welche über die NOR-Gatter $N^*$ der jeweils zugehörigen Flip-Flopzellen $FF_j$ dafür sorgt, daß alle diese Flip-Flopzellen $FF_j$ im ersten Betriebszustand verbleiben und die von ihnen gesteuerten Schaltungsteile $St_j$ im inaktiven Zustand festgehalten werden. Somit kippt nur die Flip-Flopzelle $FF_i$ in den zweiten Betriebszustand, wodurch der zugehörige Schaltungsteil $St_i$ aktiviert wird.

Werden hingegen wenigstens zwei der Bedienungsschalter $B_i$ gleichzeitig betätigt, so wird auf jeden Fall durch eines der AND-Gatter $AN_i$ an das OR-Gatter OR eine »1« gelangen, welches diese »1« an die zweiten Eingänge aller je einen Ausgang $A_i$ der Logikschaltung L steuernden NOR-Gatter $N_i$ weitergibt. Dadurch liegt an den Ausgängen aller dieser NOR-Gatter $N_i$ eine »0«,

so daß der bisherige Betriebszustand der Flip-Flopzellen $FF_i$ erhalten bleibt.

Wird hingegen nur ein einziger Bedienungsschalter $B_i$ betätigt, so wird, wie bereits beschrieben, die zugehörige Flip-Flopzelle $FF_i$ aktiviert. Da an den Ausgängen der (n−1) OR-Gatter $O_j$ mit j ≠ i dann auf jeden Fall eine »1«, an dem Ausgang des OR-Gatters $O_i$ hingegen eine »0« erscheint, kippt eine sich im zweiten Betriebszustand befindende Flip-Flopzelle $FF_j$ aufgrund der Betätigung des Bedienungsschalters $B_i$ in den ersten Betriebszustand zurück, womit eine Abschaltung des der Flip-Flopzelle $FF_j$ zugeordneten Schaltungsteils $St_j$ verbunden ist.

Ersichtlich bildet der aus den AND-Gattern $AN_i$ und den OR-Gattern $OR_i$ bzw. OR bestehende Teil der gemeinsamen Logikschaltung L zusammen mit den NOR-Gattern $N_i$ eine Sperre, welche verhindert, daß gleichzeitig mehrere Flip-Flopzellen $FF_i$ sich im zweiten Betriebszustand gleichzeitig befinden. Es wird also durch die Erfindung ein elektronischer Ersatz für auf mechanischer Grundlage arbeitenden Tastensperren bei elektronischen Musikinstrumenten geboten, durch welchen die Nachteile mechanischer Tastensperren, vor allem deren hoher Tiefgang und deren hohe Kosten, erfolgreich vermieden sind.

Die in Fig. 3 dargestellte Ausgestaltung einer digitalen Halbleiterschaltung gemäß der Erfindung unterscheidet sich von der Ausgestaltung gemäß Fig. 2 im wesentlichen nur durch etwas abweichende und in Form von Kombinationen von MOS-Feldeffekttransistoren vom Anreicherungstyp gegebene Ausgestaltung des der Erzeugung des an die NOR-Gatter $N_i$ zugebenden Sperrsignals dienenden Teils der Logik L sowie durch die Hinzufügung zweier im Falle der Verwendung von Sensorschaltern als Bedienungsschalter $B_i$ und einer Ausgestaltung der digitalen Halbleiterschaltung in monolithisch integrierter Form vorteilhafter Maßnahmen. .

Somit entspricht die in Fig. 3 dargestellte Ausführung einer Vorrichtung gemäß der Erfindung bezüglich der Ausbildung der Flip-Flopzellen $FF_i$, der Inverter $I_i$, der NOR-Gatter $N_i$, der OR-Gatter $O_i$ der Darstellung gemäß Fig. 2. Hinsichtlich des das Sperrsignal liefernden Teiles der Logikschaltung L ist insofern eine Abänderung gegeben, als die in Fig. 2 vorgesehenen OR-AND-Funktionen (also jeweils die Reihenfolge einer OR-AND-Stufe $OR_i$, $AN_i$) über einen gemeinsamen Lastwiderstand L an das erste Betriebspotential $V_{GG}$ gelegt und auf diese Weise die OR-AND-Funktion invertiert ist. Der Ausgang dieses Teils, der unter Verwendung nicht bezeichneter MOS-Feldeffekttransistoren vom Anreicherungstyp dargestellt ist, wird durch einen Inverter IN gegeben, dessen Ausgang das an die NOR-Gatter $N_i$ zu legende Sperrsignal liefert.

Bei Verwendung von Sensorschaltern als Bedienungsschalter $B_i$ empfiehlt es sich, die Offenbarungen der am 30. 4. 1979 eingereichten

De-Patentanmeldung P 29 17 596.0 (= EP-AI 80 102 143.7) zu berücksichtigen. Diese Patentanmeldung betrifft eine monolithisch integrierte digitale Halbleiterschaltung mit MIS-Feldeffekttransistoren und einem als Signaleingang zu verwendenden elektrischen Anschluß an dem die Halbleiterschaltung enthaltenden Halbleiterkörper. Diese digitale Halbleiterschaltung ist dadurch gekennzeichnet, daß der elektrische Anschluß des Halbleiterkörpers über einen manuell zu betätigenden Sensorschalter mit dem einen der zum Betrieb der digitalen Halbleiterschaltung notwendigen Betriebspotentiale beaufschlagt und im Inneren des Halbleiterkörpers durch die Source-Drainstrecke eines durch einen auf sein Gate zu gebenden elektrischen Impuls in den leitenden Zustand zu versetzenden ersten MIS-Feldeffekttransistor mit dem anderen der beiden Betriebspotentiale der Halbleiterschaltung verbunden ist, daß ferner der elektrische Anschluß des Halbleiterkörpers mit einem der Anschlüsse eines der eigentlichen digitalen Halbleiterschaltung angehörigen und eine UND-Funktion (= AND-Funktion) darstellenden weiteren Schaltungsteils verbunden ist und daß schließlich eine den für die Aktivierung des ersten MIS-Feldeffekttransistors benötigten Impuls $\Phi_1$ und den für die Aktivierung des zweiten Schaltungsteils benötigten Impuls $\Phi_2$ abgebende Impulserzeugungsanlage vorgesehen ist. In der Anmeldung P 29 17 596.0 sind verschiedene Ausgestaltungen einer solchen monolithisch integrierten digitalen Halbleiterschaltung beschrieben.

Diese monolithisch integrierten digitalen Halbleiterschaltungen können nach Betätigung des Sensorschalters ein die Weitergabe des hierdurch entstandenen Signals an die eigentliche digitale Halbleiterschaltung bestätigendes Antwortsignal erzeugen und dieses über den genannten elektrischen Anschluß des Halbleiterkörpers an eine externe Anzeigevorrichtung, z. B. eine Leuchtdiode, weiter geben.

Bei einer Übertragung der in der DE-Patentanmeldung P 29 17 596.0 beschriebenen Maßnahmen auf die vorliegende Erfindung ist jeder Eingang $E_i$ der Logikschaltung L durch je einen Anschluß des Halbleiterkörpers, der die Gesamtschaltung mit Ausnahme der Anzeigevorrichtung aufnimmt, gegeben. Jedem der Eingänge $E_i$ ist dann jeweils ein Exemplar der in der genannten Anmeldung beschriebenen Schaltungen zugeordnet, wobei als Impulserzeugungsanlage ein durch einen — ggf. gemeinsamen Oszillator O gesteuerter Dualzähler Z verwendet werden kann. Dieser Dualzähler Z liefert über einen Dekoder den für den jeweiligen Transistor $T_1$ (also dem ersten Transistor gemäß der in der Patentanmeldung P 29 17 596.0 gegebenen Definition) erforderlichen Gateimpuls $\Phi_1$, so daß der durch Betätigung des Sensorschalters $B_i$ elektrische aufgeladene Anschluß $E_i$ durch Kontakt mit dem Bezugspotential $V_{SS}$ über den Transistor $T_1$ entladen wird. Außerdem sorgt der Zähler Z über den Dekoder für die Entstehung eines zweiten

Impulses $\Phi_2$, mit dessen Hilfe schließlich das an die Gates der das Antwortsignal auf die Betätigung des Sensorschalters an den jeweiligen elektrischen Anschluß $E_i$ weiterleitenden Transistoren $T_2$ zu legende Steuersignal erzeugt wird.

## Patentansprüche

1. Digitale Halbleiterschaltung mit mehreren, durch je einen Bedienungsschalter ($B_i$; i = 1, 2, ... n) zu aktivierenden Schaltungsteilen ($St_i$), bei der jedem dieser Bedienungsschalter je eine bistabile Kippstufe ($FF_i$) zugeordnet und der Ruhezustand dieser einzelnen Schaltungsteile dem ersten Betriebszustand und ihr aktiver Zustand dem zweiten Betriebszustand der jeweils zugehörigen bistabilen Kippstufe zugeordnet ist, und bei der außerdem eine Logikschaltung (L) derart vorgesehen ist, daß bei einer alleinigen Betätigung jedes der genannten Bedienungsschalter ($B_i$) einerseits die Aktivierung des diesem Bedienungsschalter zugeordneten Schaltungsteils ($St_i$) und andererseits die Rückschaltung jedes anderen im Zeitpunkt der Betätigung dieses Bedienungsschalters sich im aktiven Zustand befindlichen Schaltungsteils in den Ruhezustand erfolgt, beziehungsweise der Ruhezustand der übrigen Schaltungsteile beibehalten wird, dadurch gekennzeichnet, daß die einzelnen durch je einen der Bedienungsschalter ($B_i$; i = 1, 2, ... n) beaufschlagten n Signaleingänge ($E_i$) der Logikschaltung (L) über je einen Inverter ($I_i$) zur Steuerung je eines NOR-Gatters ($N_i$) dienen, daß dabei der eine Eingang dieser NOR-Gatter ($N_i$) von dem zugehörigen Inverter ($I_i$) und der zweite Eingang durch ein von einem weiteren Teil (OR, IN) der Logikschaltung (L) an alle diese NOR-Gatter ($N_i$) geliefertes Sperrsignal beaufschlagt ist, daß ferner der Ausgang der genannten NOR-Gatter ($N_i$) jeweils einen der beiden zur Steuerung der zugehörigen bistabilen Kippstufe dienenden Signalausgänge ($A_i$) der Logikschaltung (L) bildet, während der jeweils zugehörige zweite Signalausgang ($A_i^*$) durch den Ausgang jeweils eines OR-Gatters ($O_i$) gegeben ist, dessen (n − 1) Signaleingänge jeweils von je einem derjenigen Signaleingänge ($E_j$; j = i) der Logikschaltung (L) angesteuert sind, die den übrigen (n − 1) Bedienungsschaltern ($B_j$; j ≠ i) zugeordnet sind.

2. Vorrichtung nach Anspruch 1, dadurch gekennzeichnet, daß zur Erzeugung des zur Beaufschlagung der je einen Signalausgang ($A_i$) der Logikschaltung (L) bildenden NOR-Gatter ($N_i$) vorgesehenen Sperrsignals je ein durch den dem betreffenden NOR-Gatter ($N_i$) jeweils zugeordneten Signaleingang ($E_i$) der Logikschaltung (L) unmittelbar gesteuertes AND-Gatter ($AN_i$) vorgesehen ist, das im übrigen durch je ein durch die Gesamtheit der nicht dem betreffenden NOR-Gatter ($N_i$) zugeordneten Signaleingänge ($E_j$; j ≠ i) der Logikschaltung gemeinsam beaufschlagtes OR-Gatter ($OR_i$) gesteuert ist,

und daß die Gesamtheit der genannten AND-Gatter (AN$_i$) zur Beaufschlagung je eines Eingangs eines gemeinsamen weiteren OR-Gatters (OR) vorgesehen ist, dessen Ausgang mit je einem Eingang aller je einen der zur Steuerung der vorgesehenen bistabilen Kippstufen (FF$_i$) bildenden Ausgang (A$_i$) bildenden NOR-Gatter (N$_i$) verbunden ist.

3. Vorrichtung nach Anspruch 1 oder 2, dadurch gekennzeichnet, daß die je einen der zur Steuerung der vorgesehenen n bistabilen Kippstufen (FF$_i$) dienenden Signalausgänge (A$_i$; A$_i^*$) der Logikschaltung (L) bildenden NOR-Gatter (N$_i$) und OR-Gatter (O$_i$) derart miteinander kombiniert sind, daß die einzelnen NOR-Gatter (N$_i$) zur Steuerung aller derjenigen dieser OR-Gatter (O$_j$; j≠i) dienen, welche nicht zur Steuerung der gleichen bistabilen Kippstufe (FF$_i$) wie das betreffende NOR-Gatter (N$_i$) vorgesehen sind.

4. Vorrichtung nach einem der Ansprüche 1 bis 3, dadurch gekennzeichnet, daß die den zu aktivierenden Schaltungsteilen (St$_i$) jeweils zugeordneten Bedienungsschalter (B$_i$) als Sensorschalter ausgebildet sind.

5. Vorrichtung nach einem der Ansprüche 1 bis 4, dadurch gekennzeichnet, daß die bistabilen Kippstufen (FF$_i$) als RS-Flip-Flops mit Reseteingang ausgebildet sind.

6. Vorrichtung nach einem der Ansprüche 1 bis 5, dadurch gekennzeichnet, daß sie monolithisch, insbesondere unter Verwendung der MOS-Halbleitertechnik, zusammengefaßt ist.

## Claims

1. A digital semiconductor circuit comprising a plurality of stages, each activated by a control element, wherein each of these control elements is assigned a bistable flip-flop, and the rest state of these individual stages is linked to the first operating state and the active state is linked to the second operating state of the particularly assigned bistable flip-flop, and a logic circuit is provided in such manner that when each of the aforementioned control elements is actuated the stage assigned to this control element is activated, each other stage which occupies the active state at the instant of the actuation of this control element is switched back into the rest state, and the rest state of the other stages is maintained, characterised in that the individual n signal inputs (E$_i$), of the logic circuit (L), each fed by one of the control elements (B$_i$; i = 1, 2, ... n) controls a NOR gate (N$_i$) via an inverter (I$_i$), that the first input of these NOR gates (N$_i$) is fed by the associated inverter (I$_i$) and the second input is fed with a blocking signal which is supplied by a further component (OR, IN) of the logic circuit (L) to all these NOR gates (N$_i$), that moreover the output of the aforementioned NOR gates (N$_i$) forms one of the two signal outputs (A$_i$) of the logic circuit (L) which serves to control the associated bistable flip-flop, whereas the associated second signal output (A$_i^*$) is represented by the output of the OR gate (O$_i$) whose (n − 1) signal inputs are each controlled by one of those signal inputs (E$_j$; j = i) of the logic circuit (L) which are assigned to the other (n − 1) control elements (B$_j$; j = i).

2. A device as claimed in Claim 2, characterised in that an AND gate (AN$_i$) is provided for the generation of the blocking signal to supply the NOR gates (N$_i$), each of which forms a signal output (A$_i$) of the logic circuit (L), the AND gate (AN$_i$) being directly controlled by that signal output (E$_i$) of the logic circuit (L) which is assigned to the NOR gate (N$_i$) in question and which is also controlled by an OR gate (OR$_i$) which is commonly fed by all the signal inputs (E$_j$; j = i) of the logic circuit which are not assigned to the NOR gate (N$_i$) in question, and hat all the aforementioned AND gates (AN$_i$) each serve to feed one input of a common OR gate (OR) whose output is connected to one input of all the NOR gates (N$_i$) which each form an output (A$_i$) which serves to control the bistable flip-flop (FF$_i$).

3. A device as claimed in Claim 1 or 2, characterised in that the NOR gates (N$_i$) and OR gates (O$_i$), each of which form one of the signal outputs (A$_i$; A$_i^*$), to the logic circuit (L), which serve to control the provided n bistable flip-flops (FF$_i$), are combined with one another in such manner that the individual NOR gates (N$_i$) serve to control all those OR gates (O$_j$; j = i) which are not provided for the control of the same bistable flip-flop (FF$_i$) as the NOR gate (N$_i$) in question.

4. A device as claimed in one of Claims 1 to 3, characterised in that the control elements (B$_i$) which are respectively assigned to the stages (St$_i$) to be activated are designed as sensor switches.

5. A device as claimed in one of Claims 1 to 4, characterised in that the bistable flip-flops (FF$_i$) are designed as RS-type flip-flops having a reset input.

6. A device as claimed in one of Claims 1 to 5, characterised in that it is a monolithic structure, in particular formed by MOS semiconductor technology.

## Revendications

1. Circuit numérique à semiconducteurs avec des parties de circuit dont chacune est à activer par un commutateur d'exploitation, dans lequel à chacun de ces commutateurs d'exploitation est associé un étage à bascule bistable et dans lequel l'état de repos des différentes parties de circuit est relié au premier état d'exploitation et son état actif est relié au second état d'exploitation de l'étage à bascule bistable associé, et dans lequel, il est prévu, en outre, de telle manière un circuit logique que lors de la commande de chacun de ces commutateurs d'exploitation a lieu d'une part l'activation de la partie de circuit associée à ce commutateur d'exploitation et d'autre part la remise à l'état de repos de la partie de circuit qui se trouve à l'état activé à l'instant de la commande de ce commutateur d'exploitation ou le maintien à l'état de repos des autres parties de circuit, caractérisé par le fait que les différentes n entrées de signaux ($E_i$) du circuit logique (L), chargées chacune par un commutateur d'exploitation ($B_i$; $i = 1, 2, \ldots n$) servent, respectivement par l'intermédiaire d'un inverseur ($I_i$), à la commande d'une porte NON-OU ($N_i$) respective, que ce faisant l'une des entrées de ces portes NON-OU ($N_i$) est chargée par l'inverseur associé ($I_i$) et la seconde entrée par un signal de blocage (L) fourni par une autre partie (OR, IN) du circuit logique à toutes ces portes NON-OU ($N_i$), qu'en outre la sortie de chacune desdites portes NON-OU ($N_i$) forme l'une des deux sorties de signaux ($A_i$) du circuit logique (L), qui sert à la commande de l'étage à bascule bistable associé, alors que la seconde sortie associée des signaux ($A_i^*$) est donnée par la sortie d'une porte OU respective ($O_i$) dont les $(n-1)$ sorties de signaux sont commandées respectivement par celles des entrées des signaux ($E_j$; $j = i$) du circuit logique (L), qui sont associées aux autres $(n-1')$ commutateurs d'exploitation ($B_j$; $J = i$) qui restent.

2. Dispositif selon la revendication 2, caractérisé par le fait que pour produire le signal de blocage des portes NON-OU ($N_i$) dont chacune forme la sortie de signaux ($A_i$) du circuit logique (L) il est prévu une porte ET ($AN_i$) commandée directement par l'entrée de signaux ($E_i$) du circuit logique (L) qui est associée à la porte NON-OU ($N_i$) associée, et commandée par une porte OU ($OR_i$) chargée en commun par la totalité des entrées de signaux ($E_j$; $j = i$) qui ne sont pas associées à la porte NON-OU ($N_i$) concernée, et que la totalité desdites portes ET ($AN_i$) est prévue pour charger une entrée d'une porte OU (OR) supplémentaire commune, dont la sortie est reliée à l'une des entrées de toutes les portes NON-OU ($N_i$) qui constituent respectivement une sortie ($A_i$) prévue pour la commande des étages à bascules bistables (FF) prévues.

3. Dispositif selon la revendication 1 ou 2, caractérisé par le fait que les portes NON-OU ($N_i$) et les portes OU ($O_i$) qui forment respectivement les sorties ($A_i$; $A_i^*$) du circuit logique (L) qui sert à la commande des n étages à bascule bistable ($FF_i$) qui sont prévus, sont combinées entre elles de telle manière que les diverses portes NON-OU ($N_i$) servent à la commande de celles de ces portes OU ($O_j$; $j = 1$) qui ne sont pas prévues pour commander les mêmes étages à bascules bistables ($FF_i$) que la porte NON-OU ($N_i$) concernée.

4. Dispositif selon l'une des revendications 1 à 3, caractérisé par le fait que les commutateurs d'exploitation qui sont associés aux parties de circuit ($St_i$) à activer, sont réalisés sous la forme de commutateurs de détection.

5. Dispositif selon l'une des revendications 1 à 4, caractérisé par le fait que les étages à bascule bistables sont réalisés sous la forme de multivibrateurs (RS) à entrée de remise à l'état initial.

6. Dispositif selon l'une des revendications 1 à 5, caractérisé par le fait qu'il est assemblé monolithiquement, en particulier avec mise en oeuvre de la technologie des semiconducteurs MOS.

# FIG 1

FIG 2

FIG 3